# EUROPÄISCHE PATENTSCHRIFT

(11) **EP 2 228 519 B1**
(45) Veröffentlichungstag und Bekanntmachung des Hinweises auf die Patenterteilung: **11.11.2015**
(21) Anmeldenummer: 08010724.6
(22) Anmeldetag: 12.06.2008
(51) Int. Cl.: F01K 13/00, G01M 15/02, G01M 15/14, G01R 31/40

(54) **Physikalische Test-Vorrichtung für ein Inselkraftwerk und Inbetriebsetzung eines Inselkraftwerks**
Physical testing unit of an island power plant and commissioning of an island power plant
Unité de test de fonctionnement d'une centrale d'îlot et mise en service d'une centrale d'îlot

(43) Veröffentlichungstag der Anmeldung: 15.09.2010
(73) Patentinhaber: Siemens Aktiengesellschaft, 80333 München (DE)
(72) Erfinder: Kleiner, Fritz, 81827 München (DE); Speith, Markus, 63654 Büdingen (DE)

(56) Entgegenhaltungen:
- EP-A1- 1 156 342
- EP-A1- 1 528 401
- DE-A1- 19 839 636
- JP-A- 5 215 825

## Beschreibung

Die Erfindung betrifft eine physikalische Testvorrichtung und bezieht sich auf die Verwendung der physikalischen Testvorrichtung für die Inbetriebsetzung eines Inselkraftwerks. Die Erfindung betrifft ferner ein Verfahren zur Inbetriebsetzung eines Inselkraftwerks mittels einer physikalischen Testvorrichtung

Die Erfindung betrifft insbesondere die Inbetriebsetzung einer eLNG-Anlage (Gasverflüssigungsanlage mit elektrisch angetriebenen Kältemittelverdichtern), und dort v.a. die Inbetriebsetzung des einer Gasverflüssigungsanlage (=Prozessanlage) vorgeschalteten Inselkraftwerks, oder vergleichbarer Anlagen, bei denen die komplexen Prozesse der Inbetriebsetzung von Inselkraftwerk und Prozessanlage aus organisatorischen und praktischen Gründen vollständig voneinander entkoppelt sein sollen.

Kraftwerkskomponenten und -systeme müssen nach der Installation funktionsgeprüft und in ihrem Verhalten zueinander optimiert werden. Dazu müssen die Turbinen und Generatoren zumindest mit einem Teil ihrer Nennleistung belastet werden, um reale Betriebsbedingungen zu erreichen.

Das Produkt eines Kraftwerks ist elektrische Leistung und dieses Produkt muss von elektrischen Verbrauchern abgenommen werden. Die die elektrische Leistung im Kraftwerk erzeugenden Generatoren werden durch Gas- und/oder Dampfturbinen angetrieben, die nur dann belastet werden, wenn die Generatoren Leistung abgeben; die Dampfturbinen können wiederum nur dann betrieben werden, wenn die den Gasturbinen nachgeschalteten Abhitzekessel in Betrieb sind, d.h. Dampf erzeugen.

Normalerweise sind Kraftwerke an öffentliche Netze angeschlossen, die die erzeugte elektrische Leistung abnehmen und damit eine Belastung der Generatorsätze im Kraftwerk auch während der Inbetriebsetzung erlauben. Bei reinen Inselkraftwerken, wie z.B. für LNG-Anlagen, die typischerweise abseits dicht bevölkerter Gegenden angesiedelt sind, besteht diese Möglichkeit nicht; die Generatorsätze können nur mit der angeschlossenen Last im Inselnetz belastet werden.

In einer eLNG Anlage - oder in vergleichbaren Anlagen mit Inselnetz-Kraftwerk - stellen die elektrischen Antriebe der Kältemittelverdichter den Großteil der Last dar. Der Betrieb dieser Antriebe während der Inbetriebsetzungsphase der LNG-Prozessanlage ist stark abhängig vom Fortschritt der Inbetriebsetzungsarbeiten und kann nur unter großen Schwierigkeiten mit dem Inbetriebsetzungsprozess im vorgelagerten Inselkraftwerk koordiniert werden. Das Inselkraftwerk benötigt aber für die eigene Inbetriebsetzung eine bestimmte Leistungsabnahme, welche durch die fehlende Netzanbindung nicht gewährleistet ist.

Bei kleinen Gasturbinen kann man durch Vortests auf einem Prüfstand den Inbetriebsetzungsaufwand auf der Baustelle reduzieren. Bei großen Gasturbinen ist dies nicht möglich. Der finanzielle und zeitliche Aufwand für diese Tests wäre nicht zu rechtfertigen.

Eine denkbare - und öfters diskutierte Alternative - ist die Vernichtung der im Inselkraftwerk erzeugten elektrischen Energie durch Eintauchen von Elektroden in Seewasser, was bei LNG-Anlagen durchaus naheliegend ist, weil diese wegen der LNG-Tanker immer in der Nähe eines Tiefseehafens errichtet werden. Nachteilig hierbei ist aber zum einen, dass bei der Elektrolyse von Seewasser - und darauf liefe diese Methode hinaus - neben Wasserstoff und Sauerstoff auch Chlor entsteht, das in die Luft entweicht, was unter Umweltgesichtspunkten nicht akzeptabel ist. Zum anderen besteht bei dieser Methode eine Personengefährdung durch elektrische Oberflächenfelder, die hohe Schrittspannungen, d.h. Spannungen, denen ein Mensch ausgesetzt ist, wenn er in der Nähe einer hohen Potentialabgabe seine Beine auseinander stehen hat, zur Folge haben können. Weil sich die Erde und der Körper wie Folge haben können. Weil sich die Erde und der Körper wie parallel geschaltete Widerstände verhalten, fließt dabei ein möglicherweise lebensgefährlicher Strom durch den Körper.

JP 05 215 825 A und EP 1 156 342 A1 beschreiben Lasteinheiten, die zum Testen von Energieerzeugungsahlagen, insbesondere von Notstromaggregaten, zum Einsatz kommen können.

Aufgabe der Erfindung ist daher die Angabe eines vorteilhaften Vorgehens zur Inbetriebsetzung eines Inselkraftwerks sowie die Angabe eines Verfahrens zur Inbetriebsetzung eines Inselkraftwerks, die die oben genannten Nachteile überwinden.

Erfindungsgemäß wird die auf das Vorgehen zur Inbetriebsetzung eines Inselkraftwerks gerichtete Aufgabe gelöst durch die Verwendung einer physikalische Testvorrichtung für das Inbetriebsetzen eines einer eLNG-Anlage vorgeschalteten Inselkraftwerkes, mit dem ziel die Kraftwerkskomponenten und -systeme nach der Installation auf.ihre Funktion zu prüfen und in ihrem Verhalten zu optimieren, umfassend ein physikalisches Ersatz-Lastelement, welches die durch die Prozessanlage gebildete reale Last der Turbinen und Generatoren des Inselkraftwerks zumindest annähernd nachbildet.

Die Erfindung beruht auf dem Gedanken, die Inbetriebsetzung von Inselkraftwerk und Antrieben und Verdichtern in der Prozessanlage durch den Einsatz einer temporären elektrischen Last zu entkoppeln. Der Vorteil liegt in der erheblichen Verkürzung der Inbetriebsetzungsphase der eLNG-Anlage und damit erheblichen finanziellen Vorteilen für das Projekt.

Vorteilhafterweise bildet das physikalische Ersatz-Lastelement daher die Last einer eLNG-Anlage nach.

Es ist ebenfalls vorteilhaft, wenn das physikalische Ersatz-Lastelement mindestens ein Teillastelement aufweist, welches zweckmäßigerweise schaltbar ist.

Es ist weiterhin vorteilhaft, wenn das mindestens eine Teillastelement eine Widerstandsbank ist. Eine Personengefährdung durch elektrische Oberflächenfelder ist mit geschlossenen Widerstandsbänken leichter zu beherrschen, als beispielsweise beim Eintauchen von Elektroden in Seewasser. Die Entfernung von den Generatoren zu den Elektroden ist ebenfalls weniger kritisch und die Einstellung des Belastungswiderstands einfacher als bei alternativen Methoden.

Vorzugsweise ist eine Anzahl an parallelen Teillastelementen vorgesehen, die für je eine Anschlussleistung ausgelegt sind, die zwischen ca. 3 MW und 60 MW liegt, also im gängigen Anwendungsbereich von Großabnehmern wie Industriebetrieben.

Vorzugsweise umfasst die physikalische Testvorrichtung weiterhin eine Mittelspannungs-Schaltanlage für die stufenweise Zuschaltung:der Teillastelemente. Über die Mittelspannungs-Schaltanlage wird auch die elektrische Verbindung des physikalischen Ersatz-Lastelements mit dem Inselkraftwerk über einen zwischengeschalteten Anpasstransformator hergestellt.

Im erfinderischen Verfahren zur Inbetriebsetzung einer eLNG-Anlage vorgeschaltetem Inselkraftwerks mit dem Ziel die Kraftwerkskomponenten und -systeme nach der Installation auf ihre Funktion zu prüfen und in ihrem Verhalten zu optimieren, wird ein physikalisches Ersatz-Lastelement, welches eine künftige durch die Prozessanlage gegebene reale Last der Turbinen und Generatoren des Inselkraftwerks zumindest annähernd nachbildet, bereitgestellt, mit dem Inselkraftwerk verbunden und das Inselkraftwerk in Betrieb gesetzt und nach Abschluss der Inbetriebsetzung des Inselkraftwerks das physikalische Ersatz-Lastelement vom Inselkraftwerk abgekoppelt.

Vorteilhafterweise wird eine physikalische Testvorrichtung über einen Hochspannungs-Einspeiseschalter, der als Reserveabgangsfeld in einer Hochspannungsschaltanlage des Inselkraftwerks ohnehin vorhanden ist, mit dem Inselkraftwerk verbunden.

Es ist zwecksmäßig, wenn über einen Mittelspannungs-Einspeiseschalter eine elektrisch leitende Verbindung zwischen einem Anpasstransformator, der die Spannung der Hochspannungsschaltanlage auf eine Mittelspannung transformiert, und einer Mittelspannungs-Schaltanlage eines physikalischen Ersatz-Lastelements der physikalischen Testvorrichtung hergestellt wird.

Es ist vorteilhaft, wenn ein erstes Teillastelement des physikalischen Ersatz-Lastelements über einen entsprechenden Leistungsschalter mit der Mittelspannungs-Schaltanlage verbunden wird. Weitere Teillastelemente werden vorteilhafterweise ebenfalls über entsprechende Leistungsschalter mit der Mittelspannungs-Schaltanlage verbunden, so dass eine sequentielle Inbetriebsetzung mehrerer Turbosätze ohne die Gefahr hoher Kurzschlussströme erfolgen kann.

Mit der physikalischen Testvorrichtung kann die Inbetriebsetzung der Kraftwerkstechnik unabhängig vom Fortschritt der Arbeiten in der Prozessanlage erfolgen und dies hat folgende Vorteile: Die Inbetriebsetzungsarbeiten im Inselkraftwerk können frühzeitig abgeschlossen werden und das Inselkraftwerk kann danach frühzeitig gesichert elektrische Leistung, je nach Bedarf, an die Baustromversorgung bzw. in Betrieb gehende Teilprozesse in der Prozessanlage liefern. Die Inbetriebsetzungsarbeiten in der LNG-Prozessanlage werden nicht durch die Arbeiten im Inselkraftwerk beeinflusst oder behindert und die volle Kraftwerksleistung und -funktion steht bei Abschluss der Prozess-Inbetriebsetzung zur Verfügung, was eine erhebliche Verkürzung des Zeitablaufs mit sich bringt - ein enormer wirtschaftlicher Vorteil.

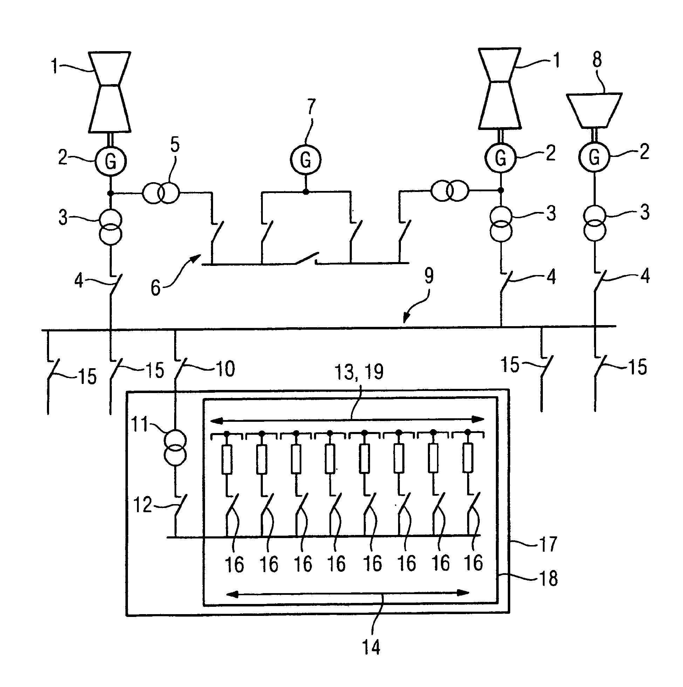

Die Erfindung wird beispielhaft anhand der Zeichnung näher erläutert. Es zeigt schematisch und nicht maßstäblich:

Fig Prinzip der physikalischen Testvorrichtung

Die Figur zeigt das Prinzip der physikalischen Testvorrichtung als einpoliges Übersichtsschaltbild: In dem der eLNG-Anlage vorgelagerten Inselkraftwerk treiben Gasturbinen 1 oder Dampfturbinen 8 Turbogeneratoren 2 an, deren elektrische Spannung hauptsächlich über Maschinentransformatoren 3 und Hochspannungseinspeiseschalter 4 an die Hochspannungs-Hauptschaltanlage 9 geleitet wird.

Für den "Schwarzstart" des Inselkraftwerks steht ein Dieselgenerator 7 zur Verfügung, der über eine Eigenbedarfsschaltanlage 6 und einen Eigenbedarfstransformator 5 die Gasturbinen 1 auf Nenndrehzahl bringen kann. Die elektrische Last der eLNG-Prozessanlage wird im späteren Betrieb über Hochspannungs-Leistungsschalter 15 abgenommen; während der Inbetriebsetzungsphase der Prozessanlage besteht diese Möglichkeit aber nicht.

Ausgehend vom Dieselgenerator 7 erfolgt der "Schwarzstart" des Inselkraftwerks, indem ein erster Gasturbinen-Generator 2 über einen Frequenzumrichter (nicht dargestellt) auf die Nenndrehzahl der Gasturbine 1 gebracht wird. Während dieser Hochlaufphase wird der Generator als Motor im frequenzgeregelten Betrieb gefahren. Nach erfolgreicher Zündung der Gasturbine 1 werden der Frequenzumrichter und der Dieselgenerator 7 abgeschaltet bzw. auf den nächstfolgenden Generator 2 geschaltet, der angefahren werden soll. Sobald die Erregung des ersten Generators 2 zugeschaltet wird, erzeugt der Generator 2 Spannung, die über die Höhe des Erregerstroms eingestellt werden kann. Die Frequenz der erzeugten Spannung wird über die Drehzahlregelung der Gasturbine 1 eingestellt und sehr präzise gehalten. Elektrische Leistung kann der Generator 2 erst erzeugen, wenn Strom fließt bzw. eine Last an die erzeugte Spannung angeschlossen wird. Im dargestellten Fall ist dies nur der Eigenbedarf der Kraftwerks-Hilfsbetriebe, solange die Leistungsschalter 15 zum LNG-Prozess geöffnet sind. Die Belastung des Generators 2 und damit der Gasturbine 1 mit dem reinen Eigenbedarf ist aber nicht ausreichend für eine volle Inbetriebsetzung der Kraftwerkstechnik.

Die erfindungsgemäße Vorrichtung, d.h. die physikalische Testvorrichtung 17, umfasst ein physikalisches Ersatz-Lastelement 18, einen Anpasstransformator 11 für die Transformation der Hochspannung der Hauptschaltanlage 9 auf Mittelspannung und einen Mittelspannungs-Einspeiseschalter 12.

Das physikalische Ersatz-Lastelement 18 umfasst Teillastelemente 19, insbesondere Widerstandsbänke 13, die zur Anpassung der Netzbelastung and die Erfordernisse der Kraftwerks-Inbetriebsetzung über Leistungsschalter 16 stufenweise in eine Mittelspannungs-Schaltanlage 14 des physikalischen Ersatz-Lastelements 18 geschaltet werden können.

Die Widerstandsbänke 13 sind kommerziell verfügbare und typgeprüfte Gitterelemente mit forcierter Luftkühlung. Die Widerstandsbänke 13 sind ausgelegt für eine Anschlussspannung im Anwendungsbereich für Großabnehmer wie Industriebetriebe, also im Mittelspannungsbereich (zwischen 3 kV und 60 kV), z.B. 20 kV. Die Widerstandsbänke 13 sind installiert in Schutzgehäusen und auf Transportschlitten, sogenannten "skids", oder in belüftbaren Containern, geeignet zum Transport auf die Baustelle mit Bahn, LKW, Schiff oder Barge. Die mechanische Ausführung der Gitterelemente kann dem Einsatzort angepasst werden. Aus Berührungsschutzgründen und zum mechanischen Schutz der eigentlichen Widerstände ist ein Gitter in Form eines Metallkäfigs aber notwendig - es darf dabei nur die Entwärmung der Widerstände nicht behindern. Der elektrische Anschluss der Widerstandbänke erfolgt in jedem Fall über Mittelspannungskabel an die Mittelspannungs-Schaltanlage 14.

Um die Belastung des Generators stufig an die Erfordernisse der Inbetriebsetzung anzupassen, wird die gesamte Widerstandsanordnung in acht Einzel-Widerstandsbänke 13 gleicher Größe aufgeteilt. Eine hiervon abweichende Anzahl an Widerstandbänken 13 ist natürlich ebenfalls möglich. Die einzelnen Widerstandsbänke 13 werden mit jeweils einem Satz Kabel mit einem entsprechenden Leistungsschalter 16 in der Mittelspannungs-Schaltanlage 14 verbunden. Somit kann die Belastung des Generators 2, ausgehend vom reinen Kraftwerks-Eigenbedarf, stufig von beispielsweise Eigenbedarf+7,5 MW auf insgesamt Eigenbedarf+60 MW erhöht werden, was für eine Inbetriebsetzung der Thermodynamik und der Leittechnik des Inselkraftwerks ausreicht.

Da Eingriffe wie z.B. temporäre Anschlüsse von solchen Widerstandsbänken an die Generatorableitungen wegen der hohen Kurzschlussströme an dieser Stelle gefährlich sind, und eine sequentielle Inbetriebsetzung mehrerer Turbosätze erschwert wäre, arbeitet die erfinderische Vorrichtung mit einem Anschluss der physikalischen Testvorrichtung 17 direkt an die Hochspannungs-Hauptschaltanlage 9 des Inselkraftwerks und einem entsprechenden Anpasstransformator 11 für die Anpassung der Spannung der Hochspannungs-Hauptschaltanlage 9 auf die Anschlussspannung der Widerstandsbänke 13 des physikalischen Ersatz-Lastelements 18. Die Anbindung des physikalischen Ersatz-Lastelements 18 an die Hochspannungs-Hauptschaltanlage 9 erfolgt über einen Mittelspannungs-Einspeiseschalter 12 über den die vom Anpasstransformator 11 gelieferte Mittelspannung in die Mittelspannungs-Schaltanlage 14 eingespeist wird.

Der für den direkten Anschluss der physikalischen Testvorrichtung 17 an die Hochspannungs-Hauptschaltanlage 9 des Inselkraftwerks notwendige Hochspannungs-Einspeiseleistungsschalter 10 ist in der Regel als Reserveabgangsfeld in der Hochspannungs-Hauptschaltanlage 9 vorhanden. Der jeweils zur Inbetriebsetzung freigegebene Turbosatz kann dann per Schalterbefehl der physikalischen Testvorrichtung 17 zugeordnet werden.

Die dargestellte physikalische Testvorrichtung 17, ggf. abzüglich des Hochspannungs-Einspeiseleistungsschalters 10, ist nur temporär erforderlich und kann deshalb beweglich aufgebaut werden - nach Abschluss der Inbetriebsetzungsarbeiten ist sie nicht mehr erforderlich.

## Patentansprüche

1. Verwendung einer physikalischen Testvorrichtung (17) für das Inbetriebsetzen eines einer eLNG-Anlage vorgeschalteten Inselkraftwerks, mit dem Ziel die Kraftwerkskomponenten und - systeme nach der Installation auf ihre Funktion zu prüfen und in ihrem Verhalten zu optimieren, umfassend ein physikalisches Ersatz-Lastelement (18), wobei das physikalisches Ersatz-Lastelement (18) die durch die Prozessanlage gebildete reale Last der Turbinen und Generatoren des Inselkraftwerks zumindest annähernd nachbildet.

2. Verwendung einer physikalischen Testvorrichtung (17) nach Anspruch 1, **dadurch gekennzeichnet, dass** das physikalische Ersatz-Lastelement (18) die Last einer eLNG-Anlage als Prozessanlage nachbildet.

3. Verwendung einer physikalischen Testvorrichtung (17) nach Anspruch 1 oder 2, **dadurch gekennzeichnet, dass** das physikalische Ersatz-Lastelement (18) mindestens ein Teillastelement (19) aufweist.

4. Verwendung einer physikalischen Testvorrichtung (17) nach Anspruch 3, **dadurch gekennzeichnet, dass** das mindestens eine Teillastelement (19) schaltbar ist.

5. Verwendung einer physikalischen Testvorrichtung (17) nach Anspruch 3 oder 4, **dadurch gekennzeichnet, dass** das mindestens eine Teillastelement (19) eine Widerstandsbank ist.

6. Verwendung einer physikalischen Testvorrichtung (17) nach einem der Ansprüche 3 bis 5, **dadurch gekennzeichnet, dass** eine Anzahl an Teillastelementen (19) vorgesehen ist, die für je eine Anschlussleistung ausgelegt sind, die zwischen 3 MW und 60 MW liegt.

7. Verwendung einer physikalischen Testvorrichtung (17) nach einem der vorhergehenden Ansprüche, **dadurch gekennzeichnet, dass** sie weiter eine Mittelspannungs-Schaltanlage (14) für die stufenweise Zuschaltung der Teillastelemente (19) umfasst.

8. Ein Verfahren zur Inbetriebsetzung eines einer eLNG-Anlage vorgeschalteten Inselkraftwerks, mit den Ziel die Kraftwerkskomponenten und -systeme nach der Installation auf ihre Funktion zu prüfen und in ihrem Verhalten zu optimieren, **dadurch gekennzeichnet, dass** ein physikalisches Ersatz-Lastelement (18), welches eine künftige durch die Prozessanlage gegebene reale Last der Turbinen und Generatoren des Inselkraftwerks zumindest annähernd nachbildet, bereitgestellt wird, mit dem Inselkraftwerk verbunden wird und das Inselkraftwerk in Betrieb gesetzt wird und nach Abschluss der Inbetriebsetzung des Inselkraftwerks das physikalische Ersatz-Lastelement (18) vom Inselkraftwerk abgekoppelt wird.

9. Das Verfahren nach Anspruch 8, **dadurch gekennzeichnet, dass** über einen Hochspannungs-Einspeiseleistungsschalter (10), der als Reserveabgangsfeld in einer Hochspannungs-Hauptschaltanlage (9) des Inselkraftwerks vorhanden ist, eine das physikalische Ersatz-Lastelement (18) umfassende physikalische Testvorrichtung (17) mit dem Inselkraftwerk verbunden wird.

10. Das Verfahren nach Anspruch 9, **dadurch gekennzeichnet, dass** über einen Mittelspannungs-Einspeiseschalter (12) eine elektrisch leitende Verbindung zwischen einem Anpasstransformator (11), der die Spannung der Hochspannungs-Hauptschaltanlage (9) auf eine Mittelspannung transformiert, und einer Mittelspannungs-Schaltanlage (14) des physikalischen Ersatz-Lastelements (18) der physikalischen Testvorrichtung (17) hergestellt wird.

11. Das Verfahren nach Anspruch 10, **dadurch gekennzeichnet, dass** ein erstes Teillastelement (19) des physikalischen Ersatz-Lastelements (18) über einen entsprechenden Leistungschalter (16) mit der Mittelspannungs-Schaltanlage (14) verbunden wird.

## Claims

1. Use of a physical testing unit (17) for commissioning an island power plant connected upstream of an eLNG plant, with the aim of testing the functions of the power plant components and systems after installation and optimizing them in their behaviour, comprising a physical dummy load element (18), the physical dummy load element (18) at least approximately simulating the actual load of the turbines and generators of the island power plant that is formed by the process plant.

2. Use of a physical testing unit (17) according to Claim 1, **characterized in that** the physical dummy load element (18) simulates the load of an eLNG plant as the process plant.

3. Use of a physical testing unit (17) according to Claim 1 or 2, **characterized in that** the physical dummy load element (18) has at least one partial load element (19).

4. Use of a physical testing unit (17) according to Claim 3, **characterized in that** the at least one partial load element (19) is switchable.

5. Use of a physical testing unit (17) according to Claim 3 or 4, **characterized in that** the at least one partial load element (19) is a bank of resistors.

6. Use of a physical testing unit (17) according to one of Claims 3 to 5, **characterized in that** a number of partial load elements (19) are provided, each designed for a connected power that lies between 3 MW and 60 MW.

7. Use of a physical testing unit (17) according to one of the preceding claims, **characterized in that** it also comprises a medium-voltage switchgear (14) for the staged cutting in of the partial load elements (19).

8. Method for commissioning an island power plant connected upstream of an eLNG plant, with the aim of testing the functions of the power plant components and systems after installation and optimizing them in their behaviour, **characterized in that** a physical dummy load element (18) which at least approximately simulates a future actual load of the turbines and generators of the island power plant that is produced by the process plant is provided and is connected to the island power plant and the island power plant is commissioned and, after completion of the commissioning of the island power plant, the physical dummy load element (18) is decoupled from the island power plant.

9. Method according to Claim 8, **characterized in that** a physical testing unit (17) comprising the physical dummy load element (18) is connected to the island power plant by way of a high-voltage incoming-feeder circuit breaker (10), which is present as a back-up outgoing-feeder panel in a main high-voltage switchgear (9) of the island power plant.

10. Method according to Claim 9, **characterized in that** an electrically conducting connection between a matching transformer (11), which transforms the voltage of the main high-voltage switchgear (9) to a medium voltage, and a medium-voltage switchgear (14) of the physical dummy load element (18) of the physical testing unit (17) is established by way of a medium-voltage incoming-feeder circuit breaker (12).

11. Method according to Claim 10, **characterized in that** a first partial load element (19) of the physical dummy load element (18) is connected to the medium-voltage switchgear (14) by way of a corresponding circuit breaker (16).

## Revendications

1. Utilisation d'un dispositif ( 17 ) de test physique pour la mise en service d'une centrale d'îlot montée en amont d'une installation eLNG, en vue de contrôler, le fonctionnement des composants de la centrale et des systèmes de la centrale après l'installation et d'en optimiser le comportement, comprenant un élément ( 18 ) de charge de remplacement physique, l'élément ( 18 ) de charge de remplacement physique reproduisant au moins à peu près la charge réelle, formée par l'installation de processus, des turbines et des génératrices de la centrale d'îlot.

2. Utilisation d'un dispositif (17 ) de test physique suivant la revendication 1, **caractérisée en ce que** l'élément ( 18 ) de charge de remplacement physique reproduit la charge d'une installation eLNG comme installation de processus.

3. Utilisation d'un dispositif ( 17 ) de test physique suivant la revendication 1 ou 2, **caractérisée en ce que** l'élément ( 18 ) de charge de remplacement physique comporte au moins un élément de charge partielle.

4. Utilisation d'un dispositif ( 17 ) de test physique suivant la revendication 3, **caractérisée en ce que** le au moins un élément ( 19 ) de charge partielle peut être mis en circuit.

5. Utilisation d'un dispositif ( 17 ) de test physique suivant la revendication 3 ou 4, **caractérisée en ce que** le au moins un élément ( 19 ) de charge partielle est un banc de résistance.

6. Utilisation d'un dispositif ( 17 ) de test physique suivant l'une des revendications 3 à 5, **caractérisée en ce qu'**il est prévu un certain nombre d'éléments ( 19 ) de charge partielle qui sont conçus pour respectivement une puissance connectée comprise entre 3 MW et 60 MW.

7. Utilisation d'un dispositif ( 17 ) de test physique suivant l'une des revendications précédentes, **caractérisée en ce qu'**elle comprend en outre une installation ( 14 ) de distribution de moyenne tension pour la connexion par étape des éléments ( 19 ) de charge partielle.

8. Procédé de mise en service d'une centrale d'îlot montée en amont d'une installation eLNG dans le but de contrôler le fonctionnement de composants de la centrale et de systèmes de la centrale après l'installation et d'optimiser leur comportement, **caractérisé en ce que** l'on met à disposition un élément ( 18 ) de charge de remplacement physique, qui reproduit au moins à peu près une charge réelle, donnée dans le futur par l'installation de processus, de la centrale d'îlot, on la relie à la centrale d'îlot et on met la centrale d'îlot en fonctionnement et, après la fin de la mise en service de la centrale d'îlot, on découple l'élément ( 18 ) de charge de remplacement physique de la centrale d'îlot.

9. Procédé suivant la revendication 8, **caractérisé en ce que**, par un disjoncteur ( 10 ) d'alimentation de haute tension, qui est présent sous la forme d'un panneau de départ de réserve dans une installation ( 9 ) de distribution principale de haute tension de la centrale d'îlot, on relie à la centrale d'îlot un dispositif ( 17 ) de test physique comprenant un élément ( 18 ) de charge de remplacement physique.

10. Procédé suivant la revendication 9, **caractérisé en ce que**, par un interrupteur ( 12 ) d'alimentation de moyenne tension, on produit une liaison conductrice de l'électricité entre un transformateur ( 11 ) d'adaptation, qui transforme la tension de l'installation ( 9 ) de distribution principale de haute tension en une tension moyenne, et une installation ( 14 ) de distribution de moyenne tension de l'élément ( 18 ) de charge de remplacement physique du dispositif ( 17 ) de test physique.

11. Procédé suivant la revendication 10, **caractérisé en ce que** l'on relie un premier élément de charge partielle de l'élément ( 18 ) de charge de remplacement physique à l'installation ( 14 ) de distribution de moyenne tension par un disjoncteur ( 16 ) adéquat.
